Europäisches Patentamt

European Patent Office

Office européen des brevets

(19)

(11) **EP 0 798 863 A1**

## (12) DEMANDE DE BREVET EUROPEEN

(43) Date de publication:
01.10.1997 Bulletin 1997/40

(51) Int. Cl.⁶: **H03M 1/06**, G06F 5/06
// H03M1/36

(21) Numéro de dépôt: 97200843.7

(22) Date de dépôt: 21.03.1997

(84) Etats contractants désignés:
**DE FR GB NL**

(30) Priorité: **29.03.1996 FR 9604001**

(71) Demandeur: **PHILIPS ELECTRONICS N.V.**
**5621 BA  Eindhoven (NL)**

(72) Inventeurs:
• **Le Pailleur, Laurent**
**75008 Paris (FR)**
• **van de Plassche, Rudy**
**75008 Paris (FR)**

(74) Mandataire: **Caron, Jean**
**Société Civile S.P.I.D.**
**156, Boulevard Haussmann**
**75008 Paris (FR)**

(54) **Convertisseur analogique/numérique à fréquence d'échantillonnage élevée**

(57)     La présente invention concerne un convertisseur analogique/numérique, dans lequel un étage de mémorisation reçoit le résultat d'une série de comparaisons d'une tension analogique d'entrée Vin avec un jeu de tensions de référence Vi (pour i=0 à Q).

Selon l'invention, chaque cellule mémoire Mi (pour i=0 à Q) qui compose l'étage de mémorisation comporte comporte N bascules dites bascules mémoire L0, L1,...LN-1, un multiplexeur Mx et un module logique CL dit module de commande. Toutes les entrées de données des bascules mémoire L0, L1,...LN-1 sont reliées ensemble à l'entrée de données de la cellule mémoire Mi. La jème bascule mémoire (pour j=0 à N-1) reçoit sur son entrée d'horloge le signal d'horloge retardé, par l'intermédiaire d'une cellule à retard, de j.T/N , où T est la période du signal d'horloge. Les sorties de données des N bascules mémoire L0, L1,...LN-1 sont reliées aux N entrées de données du multiplexeur Mx dont les P entrées de commande reçoivent les P sorties Sel0, Sel1,...SelP-1 du module de commande CL telles que le multiplexeur Mx délivre sur sa sortie, pendant chaque (j+1)ème fraction de période de durée T/N, le signal de sortie de la jème bascule mémoire Lj.

Une telle structure des cellules mémoire permet de minimiser l'influence des phénomènes de métastabilité dont les effets peuvent engendrer des erreurs lors de la mémorisation des signaux analogiques de sortie des comparateurs.

Application : Convertisseur analogique/numérique à fréquence d'échantillonnage élévée.

FIG.2

**Description**

La présente invention concerne un convertisseur analogique/numérique, recevant une tension d'entrée analogique à convertir en un signal de sortie numérique, comprenant :

.    une échelle de résistances placées en série entre une borne positive et une borne négative d'alimentation, résistances fournissant à leurs noeuds intermédiaires une pluralité de tensions dites de référence,

.    un étage de comparateurs, chacun réalisant la comparaison de la tension d'entrée analogique avec l'une des tensions de référence,

.    un étage de mémorisation composé d'éléments de mémorisation dits cellules mémoire, chaque cellule mémoire étant munie d'une entrée de données, d'une sortie de données et d'une entrée d'horloge, et recevant sur son entrée de données le signal de sortie d'un comparateur, toutes les cellules mémoire composant l'étage de mémorisation recevant sur leurs entrées d'horloge un même signal dit signal d'horloge,

.    un encodeur binaire, lequel encodeur reçoit en entrée les sorties de l'étage de mémorisation et fournit le signal de sortie numérique du convertisseur.

Un tel convertisseur analogique/numérique, couramment appelé convertisseur parallèle, est décrit dans l'article "An 8-bit Video ADC Incorporating Folding and Interpolation Techniques" de MM. Rob E. Van de Grift, Ivo W.J.M. Rutten et Martien Van der Veen paru dans le IEEE Journal of Solid-State Circuits, vol. sc-22 n°6, de Décembre 1987.

Les cellules mémoire mises en oeuvre dans ce convertisseur présentent des problèmes de métastabilité dans le cadre d'applications dans lesquelles la fréquence d'échantillonnage, qui est définie comme le nombre de fois par seconde où une représentation numérique de la tension analogique d'entrée est mémorisée, est élevée, c'est-à-dire lorsqu'elle se rapproche d'une fréquence limite définie intrinsèquement par le procédé de fabrication utilisé pour la réalisation du circuit. En effet, le passage de l'analogique au numérique se produit au niveau de la mémorisation de l'état des sorties des comparateurs, qui sont des signaux analogiques, par les cellules mémoire, dont les sorties numériques commutent à la cadence imposée par le signal d'horloge. La théorie statistique de la métastabilité démontre que la probabilité pour qu'une erreur intervienne lors de la mémorisation d'un signal analogique présentant un état transitoire augmente fortement avec la fréquence F du signal d'horloge qui cadence la cellule mémoire qui doit mémoriser ledit signal analogique : on démontre en effet que, si FI est la fréquence limite intrinsèque au procédé de fabrication, la probabilité d'erreur est de l'ordre de exp(1-FI/F). Dans le cas du convertisseur analogique/numérique décrit dans l'article "An 8-bit Video ADC Incorporating Folding and Interpolation Techniques", la fréquence du signal d'horloge cadençant les cellules mémoires est égale à la fréquence d'échantillonnage Fe. La probabilité pour qu'une erreur due aux phénomènes de métastabilité se produise lors de la mémorisation de l'état des sorties des comparateurs est alors de l'ordre de exp(1-FI/Fe).

La présente invention a pour but de minimiser l'influence de ces phénomènes de métastabilité, particulièrement à fréquence d'échantillonnage élevée, en proposant un convertisseur analogique/numérique qui, pour une fréquence d'échantillonnage donnée, utilise pour cadencer les cellules mémoire un signal d'horloge dont la fréquence est égale à une fraction de la fréquence d'échantillonnage.

En effet, un convertisseur analogique-numérique selon l'invention est caractérisé en ce que chaque cellule mémoire de l'étage de mémorisation comporte N bascules dites bascules mémoire, un multiplexeur et un module logique dit module de commande, chaque bascule mémoire étant munie d'une entrée de données, d'une sortie de données et d'une entrée d'horloge, le multiplexeur étant muni de N entrées de données, d'une sortie formant la sortie de cellule mémoire, et de P entrées de commande, N et P étant tels que $N=2^P$, le module de commande étant muni de N entrées et de P sorties, les entrées de données des bascules mémoire étant toutes reliées ensemble à l'entrée de données de la cellule mémoire, la jème bascule mémoire (pour j=0 à N-1) recevant sur son entrée d'horloge le signal d'horloge retardé de j.T/N, où T est la période du signal d'horloge, les sorties de données des N bascules mémoire étant reliées aux N entrées de données du multiplexeur dont les P entrées de commande sont reliées aux P sorties du module de commande, module de commande dont chacune des N entrées est reliée à l'une des entrées d'horloge des N bascules, et dont les P sorties sont telles que le multiplexeur délivre sur sa sortie, pendant chaque (j+1)ème fraction de période de durée T/N, le signal de sortie de la jème bascule mémoire.

Dans un tel convertisseur analogique/numérique, N représentations numériques de la tension analogique d'entrée sont mémorisées pendant une même période du signal d'horloge. La fréquence du signal d'horloge qui cadence chacune des bascules mémoire qui sont contenues dans les cellules mémoire d'un tel convertisseur est donc N fois inférieure à la fréquence d'échantillonnage, ce qui diminue considérablement la probabilité pour qu'une erreur due aux phénomènes de métastabilité se produise. En effet, celle-ci est alors de l'ordre de exp(1-N.FI/Fe), où Fe représente la fréquence d'échantillonnage.

Un mode de réalisation de l'invention présente un convertisseur analogique/numérique tel que décrit ci-dessus, caractérisé en ce que les bascules mémoire contenues dans les cellules mémoire de l'étage de mémorisation sont des bascules D.

Outre leur fonction de mémorisation, les bascules D réalisent une amplification du signal d'entrée. Il peut être intéressant d'en placer plusieurs en série au sein d'une même bascule mémoire, afin de multiplier le gain présenté par cette bascule mémoire.

Un mode de réalisation avantageux de l'invention présente donc un convertisseur analogique/numérique caractérisé en ce que les bascules mémoire contenues dans les cellules mémoire de l'étage de mémorisation sont des bascules de type Maître-Esclave.

Un mode de réalisation particulier de l'invention présente un convertisseur analogique/numérique caractérisé en ce que chaque cellule mémoire de l'étage de mémorisation comporte deux bascules dites bascules mémoire et un multiplexeur, chaque bascule mémoire étant munie d'une entrée de données, d'une sortie de données et d'une entrée d'horloge, le multiplexeur étant muni de deux entrées de données et d'une entrée de commande, les entrées de données des deux bascules mémoire étant reliées l'une à l'autre et formant l'entrée de données de la cellule mémoire, une des bascules mémoire recevant sur son entrée d'horloge le signal d'horloge, l'autre recevant sur son entrée d'horloge l'inverse dudit signal, les sorties de données des deux bascules mémoire étant reliées aux entrées de données du multiplexeur dont l'entrée de commande reçoit le signal d'horloge et dont la sortie forme la sortie de la cellule mémoire.

Un tel convertisseur analogique/numérique constitue un cas particulier de mise en oeuvre de l'invention. En effet, les bascules mémoire contenues dans une même cellule mémoire sont au nombre de deux. Un seul décalage de T/2 du signal d'horloge est donc nécessaire et est réalisé en procédant à l' inversion dudit signal. Dans un tel convertisseur analogique/numérique, la probabilité pour qu'une erreur due aux phénomènes de métastabilité se produise lors de la mémorisation de l'état des sorties des comparateurs est de l'ordre de exp(1-2.Fl/Fe).

Les phénomènes de métastabilité exposés plus haut peuvent produire des effets nuisibles dans tous les types d'applications où l'on souhaite obtenir une représentation numérique d'une tension analogique en utilisant des cellules mémoire cadencées par un signal d'horloge de fréquence élevée. Un convertisseur analogique/numérique utilisant les techiques de repliement et d'interpolation, objet de l'article "An 8-bit Video ADC Incorporating Folding and Interpolation Techniques" cité plus haut, est donc susceptible de subir de tels effets nuisibles à fréquence d'échantillonnage élevée, ainsi qu'exposé plus haut.

L'invention concerne donc également un convertisseur analogique/numérique, recevant une tension d'entrée analogique à convertir en un signal de sortie numérique, comprenant :

. une échelle de résistances placées en série entre une borne positive et une borne négative d'alimentation, résistances fournissant à leurs noeuds intermédiaires une pluralité de tensions dites de référence,

. des étages dits de repliement, composés chacun d'un jeu de comparateurs agencés de manière à engendrer un signal, dit de repliement, évoluant de manière quasi-sinusoïdale avec la tension analogique d'entrée, et un signal opposé à ce signal de repliement,

. un premier et un deuxième étages d'interpolation, le premier recevant les signaux de repliement, le second recevant leurs opposés, chaque étage d'interpolation étant composé d'éléments d'impédance, de préférence des résistances de même valeur, montés en pont diviseur de manière à ce que les signaux, dits signaux d'échantillonnage, engendrés aux bornes des éléments du premier étage d'interpolation représentent des divisions des signaux de repliement, les signaux engendrés par le deuxième étage d'interpolation leur étant opposés,

. un détecteur de cycle recevant les signaux de repliement et leurs opposés et fournissant des signaux dits pointeurs de cycle et des signaux opposés à ceux-ci, permettant d'identifier celui des cycles des signaux d'échantillonnage qui est significatif de la valeur de la tension analogique d'entrée,

. un premier étage de mémorisation composé d'éléments de mémorisation, dits cellules mémoire, chaque cellule mémoire étant munie de deux entrées de données, d'une sortie de données et d'une entrée d'horloge et recevant sur ses entrées de données un signal d'échantillonnage et son opposé, chaque cellule mémoire comportant un comparateur d'entrée dont les entrées sont reliées aux entrées de données de la cellule mémoire, toutes les cellules mémoire composant le premier étage de mémorisation recevant sur leurs entrées d'horloge un même signal dit signal d'horloge,

. un deuxième étage de mémorisation composé de cellules mémoire, chacune recevant sur ses entrées de données un signal pointeur de cycle et son opposé, toutes les cellules mémoire composant le deuxième étage de mémorisation recevant sur leurs entrées d'horloge le signal d'horloge,

. un encodeur binaire, lequel encodeur reçoit en entrée les sorties des étages de mémorisation et fournit le signal de sortie numérique du convertisseur,

caractérisé en ce que les cellules mémoire des étages de mémorisation comportent chacune N bascules dites bascules mémoire, un multiplexeur et un module logique dit module de commande, chaque bascule mémoire étant munie d'une entrée de données, d'une sortie de données et d'une entrée d'horloge, le multiplexeur étant muni de N entrées de données et de P entrées de commande et d'une sortie formant la sortie de cellule mémoire, N et P étant tels que $N=2^P$, le module

mémoire étant muni de N entrées et de P sorties, toutes les entrées de données des bascules mémoire étant reliées ensemble à la sortie du comparateur d'entrée de la cellule mémoire, la jème bascule mémoire (pour j=0 à N-1) recevant sur son entrée d'horloge le signal d'horloge retardé de j.T/N, où T est la période du signal d'horloge, les sorties de données des N bascules mémoire étant reliées aux N entrées de données du multiplexeur dont les P entrées de commande sont reliées aux P sorties du module de commande, module de commande dont chacune des N entrées est reliée à l'une des entrées d'horloge des N bascules, et dont les P sorties sont telles que le multiplexeur délivre sur sa sortie, pendant chaque (j+1)ème fraction de période de durée T/N, le signal de sortie de la jème bascule mémoire.

Dans un tel convertisseur analogique/numérique, la nullité d'un signal d'échantillonnage signale l'égalité de la tension analogique d'entrée avec une des tensions de référence. Les bits de poids les plus faibles du signal de sortie numérique sont donc déterminés à l'aide de la détection des passages par zéro des signaux d'échantillonnage. Les bits de poids les plus forts sont déterminés à l'aide des signaux pointeurs de cycle, qui permettent d'identifier celui des cycles des signaux d'échantillonnage où a lieu le passage par zéro significatif, et donc de déterminer à laquelle des tensions de référence est égale la tension analogique d'entrée à l'occasion de ce passage par zéro.

Dans un tel convertisseur analogique/numérique, comme dans le cas du convertisseur parallèle, N représentations numériques de la tension analogique d'entrée sont mémorisées pendant une même période du signal d'horloge. La fréquence du signal d'horloge qui cadence chacune des bascules mémoire qui sont contenues dans les cellules mémoire d'un tel convertisseur est donc N fois inférieure à la fréquence d'échantillonnage Fe, ce qui réduit à exp(1-N.Fl/Fe) la probabilité pour qu'une erreur due aux phénomènes de métastabilité se produise.

Dans un mode de réalisation de l'invention, un convertisseur analogique/numérique utilisant les techniques de repliement et d'interpolation tel que décrit ci-dessus est caractérisé en ce que les bascules mémoire contenues dans les cellules mémoire des étages de mémorisation sont des bascules D.

Ainsi qu'exposé dans le cas du convertisseur parallèle, il peut être intéressant de placer plusieurs bascules D en série au sein d'une même bascule mémoire, afin de multiplier le gain présenté par cette bascule mémoire.

Dans un mode de réalisation avantageux de l'invention, un convertisseur analogique/numérique utilisant les techniques de repliement et d'interpolation est caractérisé en ce que les bascules mémoire contenues dans les cellules mémoire des étages de mémorisation sont des bascules de type Maître-Esclave.

Un mode de réalisation particulier de l'invention présente un convertisseur analogique/numérique tel que décrit ci-dessus, caractérisé en ce que chaque cellule mémoire de l'étage de mémorisation comporte deux bascules dites bascules mémoire et un multiplexeur, chaque bascule mémoire étant munie d'une entrée de données, d'une sortie de données et d'une entrée d'horloge, le multiplexeur étant muni de deux entrées de données et d'une entrée de commande, les entrées de données des deux bascules mémoire étant reliées ensemble à la sortie du comparateur d'entrée de la cellule mémoire, une des bascules mémoire recevant sur son entrée d'horloge le signal d'horloge, l'autre recevant sur son entrée d'horloge l'inverse dudit signal, les sorties de données des deux bascules mémoire étant reliées aux entrées de données du multiplexeur dont l'entrée de commande reçoit le signal d'horloge et dont la sortie forme la sortie de la cellule mémoire.

Un tel convertisseur analogique/numérique constitue un cas particulier de mise en oeuvre de l'invention, dans lequel les bascules mémoire contenues dans une même cellule mémoire sont au nombre de deux. Un seul décalage de T/2 du signal d'horloge est donc nécessaire et est réalisé en procédant à l'inversion dudit signal. Dans un tel convertisseur analogique/numérique, la probabilité pour qu'une erreur due aux phénomènes de métastabilité se produise lors de la mémorisation de l'état des sorties des comparateurs est de l'ordre de exp(1-2.Fl/Fe).

Les convertisseurs analogiques/numériques ne sont pas les seuls circuits dans lesquels des phénomènes de métastabilité peuvent produire des effets nuisibles. Toute mémorisation d'une tension analogique, au moyen d'une cellule mémoire cadencée par un signal d'horloge de fréquence élevée, c'est-à-dire se rapprochant de la fréquence limite définie intrinsèquement par le procédé de fabrication utilisé pour la réalisation du circuit, peut être perturbée par de tels phénomènes.

L'invention concerne donc également une cellule mémoire, munie d'une entrée de données, d'une sortie de données et d'une entrée d'horloge, laquelle reçoit un signal dit signal d'horloge, caractérisée en ce qu'elle comporte N bascules dites bascules mémoire, un multiplexeur et un module logique dit module de commande, chaque bascule mémoire étant munie d'une entrée de données, d'une sortie de données et d'une entrée d'horloge, le multiplexeur étant muni de N entrées de données, d'une sortie formant la sortie de cellule mémoire, et de P entrées de commande, N et P étant tels que $N=2^P$, le module de commande étant muni de N entrées et de P sorties, les entrées de données des bascules mémoire étant toutes reliées ensemble à l'entrée de la cellule mémoire, la jème bascule mémoire (pour j=0 à N-1) recevant sur son entrée d'horloge le signal d'horloge retardé de j.T/N, où T est la période du signal d'horloge, les sorties de données des N bascules mémoire étant reliées aux N entrées de données du multiplexeur dont les P entrées de commande sont reliées aux P sorties du module de commande, module de commande dont chacune des N entrées est reliée à l'une des entrées d'horloge des N bascules, et dont les P sorties sont telles que le multiplexeur délivre sur sa sortie, pendant chaque (j+1)ème fraction de période de durée T/N, le signal de sortie de la jème bascule mémoire.

Dans une telle cellule mémoire, N représentations numériques du signal reçu par la cellule mémoire sur son entrée de données sont mémorisées pendant une même période du signal d'horloge. La fréquence du signal d'horloge qui cadence chacune des bascules mémoire qui sont contenues dans une telle cellule mémoire est donc N fois inférieure à la fréquence d'échantillonnage Fe, ce qui réduit à exp(1-N.Fl/Fe) la probabilité pour qu'une erreur due aux phénomènes de métastabilité se produise.

Dans un mode de réalisation de l'invention, une cellule mémoire telle que décrite ci-dessus est caractérisée en ce que les bascules mémoire qu'elle contient sont des bascules D.

Ainsi qu'exposé plus haut, il peut être intéressant de placer plusieurs bascules D en série au sein d'une même bascule mémoire, afin de multiplier le gain présenté par cette bascule mémoire.

Un mode de réalisation avantageux de l'invention présente donc une cellule mémoire caractérisée en ce que les bascules mémoire qu'elle contient sont des bascules de type Maître-Esclave.

Un mode de réalisation particulier de l'invention présente une cellule mémoire, munie d'une entrée de données, d'une sortie et d'une entrée d'horloge, caractérisée en ce qu'elle comporte deux bascules dites bascule mémoire et un multiplexeur, chaque bascule mémoire étant munie d'une entrée de données, d'une sortie et d'une entrée d'horloge, le multiplexeur étant muni de deux entrées de données et d'une entrée de commande, les entrées de données des deux bascules mémoire étant reliées ensemble et formant l'entrée de la cellule mémoire, une des bascules mémoire recevant sur son entrée d'horloge le signal d'horloge reçu sur l'entrée d'horloge de la cellule mémoire, l'autre bascule mémoire recevant sur son entrée d'horloge l'inverse dudit signal, les sorties de données des deux bascules mémoire étant reliées aux entrées de données du multiplexeur dont l'entrée de commande reçoit le signal d'horloge et dont la sortie forme la sortie de la cellule mémoire.

L'invention sera mieux comprise à l'aide de la description suivante de quelques modes de réalisation, faite à titre d'exemple non limitatif et en regard des dessins annexés, dans lesquels :

- la figure 1 est un schéma fonctionnel partiel d'un convertisseur analogique/numérique parallèle conforme à l'invention,
- la figure 2 est un schéma fonctionnel d'une cellule mémoire incluse dans un convertisseur numérique/analogique parallèle conforme à l'invention,
- la figure 3 est un schéma fonctionnel d'une cellule mémoire incluse dans un convertisseur numérique/analogique parallèle conforme à un mode de réalisation particulier de l'invention,
- la figure 4 est un ensemble de chronogrammes illustrant l'évolution de signaux présents dans une telle cellule mémoire,
- la figure 5 est un schéma fonctionnel d'une cellule mémoire incluse dans un convertisseur numérique/analogique parallèle conforme à un mode de réalisation avantageux de l'invention,
- la figure 6 est un ensemble de chronogrammes illustrant l'évolution de signaux présents dans une telle cellule mémoire,
- la figure 7 est un schéma fonctionnel partiel d'un convertisseur analogique/numérique utilisant les techniques de repliement et d'interpolation conforme à l'invention,
- la figure 8 est un schéma fonctionnel d'une cellule mémoire incluse dans un convertisseur numérique/analogique utilisant les techniques de repliement et d'interpolation conforme à l'invention,
- la figure 9 est un schéma fonctionnel d'une cellule mémoire incluse dans un convertisseur numérique/analogique utilisant les techniques de repliement et d'interpolation conforme à un mode de réalisation particulier de l'invention,
- la figure 10 est un ensemble de chronogrammes illustrant l'évolution de signaux présents dans une telle cellule mémoire,
- la figure 11 est un schéma fonctionnel d'une cellule mémoire incluse dans un convertisseur numérique/analogique utilisant les techniques de repliement et d'interpolation conforme à un mode de réalisation avantageux de l'invention, et
- la figure 12 est un ensemble de chronogrammes illustrant l'évolution de signaux présents dans une telle cellule mémoire.

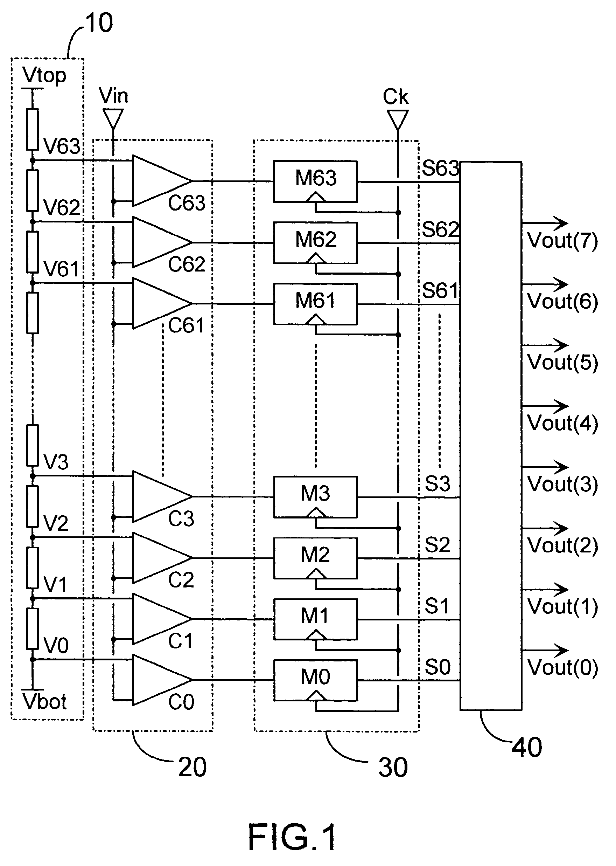

La figure 1 représente partiellement un convertisseur analogique/numérique parallèle. Dans le cas décrit ici, ce convertisseur reçoit une tension d'entrée analogique Vin à convertir en un signal de sortie numérique codé sur 8 bits Vout(0...7). Ce convertisseur comprend :

. une échelle de résistances 10, formée de 64 résistances placées en série entre une borne positive et une borne négative d'alimentation, respectivement Vtop et Vbot, résistances fournissant à leurs noeuds intermédiaires 64 tensions dites de référence, V0, V1,...V63, V0 étant égale à Vbot.

. un étage de comparateurs 20, formé de 64 comparateurs, chacun réalisant la comparaison de la tension d'entrée analogique Vin avec l'une des tensions de référence V0, V1,...V63,

. un étage de mémorisation 30 composé de 64 éléments de mémorisation dits cellules mémoire M0, M1,...M63, chaque cellule mémoire Mi (pour i=0 à 63) étant munie d'une entrée de données, d'une sortie et d'une entrée d'horloge, et recevant sur son entrée de données le signal de sortie Ci d'un comparateur, toutes les cellules mémoire M0, M1,...M63 composant l'étage de mémorisation 30 recevant sur leurs entrées d'horloge un même signal Ck dit signal d'horloge,

. un encodeur binaire 40, lequel encodeur 40 reçoit en entrée les sorties S0, S1,...S63 de l'étage de mémorisation 30 et fournit le signal de sortie numérique du convertisseur Vout(0...7).

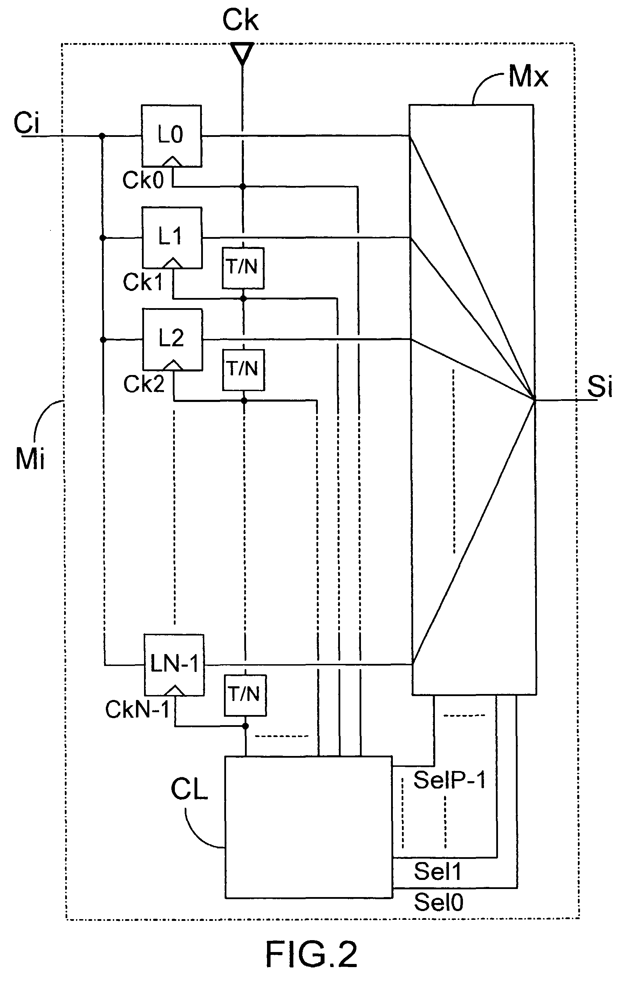

La figure 2 représente schématiquement l'une quelconque des 64 cellules mémoire que comporte l'étage de mémorisation 30 dans un convertisseur analogique/numérique parallèle conforme à l'invention. Cette cellule mémoire Mi (pour i=0 à 63) comporte N bascules dites bascules mémoire L0, L1,...LN-1, un multiplexeur Mx et un module logique CL dit module de commande. Chaque bascule mémoire L0, L1,...LN-1 est munie d'une entrée de données, d'une sortie de données et d'une entrée d'horloge. Le multiplexeur Mx est muni de N entrées de données, d'une sortie formant la sortie de cellule mémoire, et de P entrées de commande, N et P étant tels que $N=2^P$. Le module de commande CL est muni de N entrées et de P sorties. Les entrées de données des bascules mémoire L0, L1,...LN-1 sont toutes reliées ensemble à l'entrée de données de la cellule mémoire Mi. La jème bascule mémoire (pour j=0 à N-1) reçoit sur son entrée d'horloge le signal d'horloge retardé, par l'intermédiaire d'une cellule à retard, de j.T/N , où T est la période du signal d'horloge. Les sorties de données des N bascules mémoire L0, L1,...LN-1 sont reliées aux N entrées de données du multiplexeur Mx dont les P entrées de commande sont reliées aux P sorties du module de commande CL. Chacune des N entrées du module de commande CL est reliée à l'une des entrées d'horloge Ck0, Ck1,...CkN-1 des N bascules mémoire. Les P sorties Sel0, Sel1,...SelP-1 du module de commande CL sont telles que le multiplexeur Mx délivre sur sa sortie, pendant chaque (j+1)ème fraction de période de durée T/N, le signal de sortie de la jème bascule mémoire Lj.

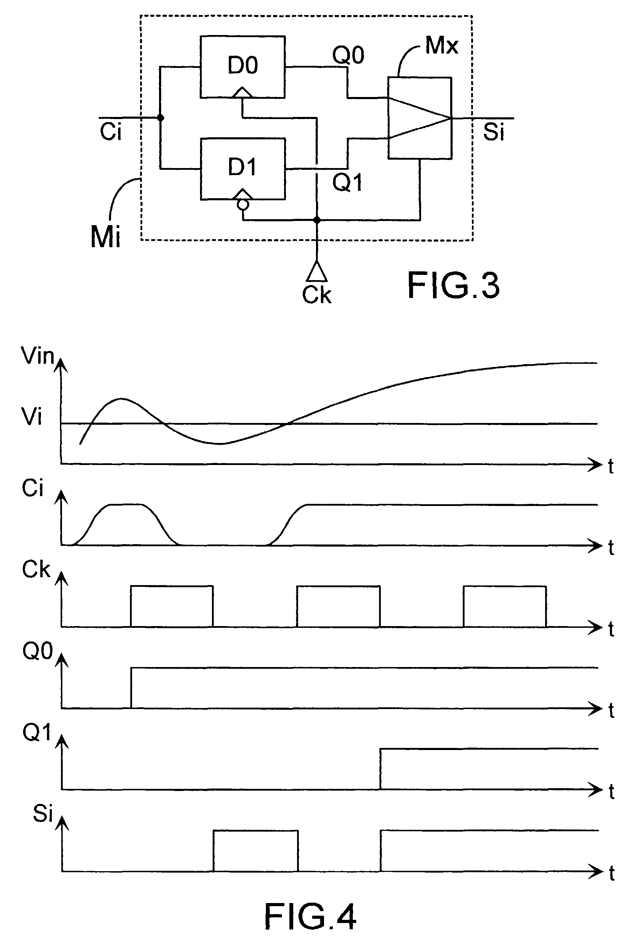

La figure 3 représente schématiquement l'une quelconque des 64 cellules mémoire que comporte l'étage de mémorisation 30 dans un convertisseur analogique/numérique parallèle conforme à un mode de réalisation particulier de l'invention. Cette cellule mémoire Mi (pour i=0 à 63) comporte deux bascules D, D0 et D1, dites bascules mémoire et un multiplexeur Mx. Chaque bascule mémoire D0, D1 est munie d'une entrée de données, d'une sortie et d'une entrée d'horloge. Le multiplexeur Mx est muni de deux entrées de données et d'une entrée de commande. Les entrées de données des deux bascules mémoire D0 et D1 sont reliées l'une à l'autre et forment l'entrée de données de la cellule mémoire. Une des bascules mémoire, D0, reçoit sur son entrée d'horloge le signal d'horloge Ck, l'autre, D1, reçoit sur son entrée d'horloge l'inverse dudit signal Ck. Les sorties de données des deux bascules mémoire D0 et D1 délivrent des signaux Q0 et Q1 et sont reliées aux entrées de données du multiplexeur Mx dont l'entrée de commande reçoit le signal d'horloge Ck et dont la sortie forme la sortie de la cellule mémoire Mi.

La figure 4 est un ensemble de chronogrammes illustrant l'évolution de signaux présents dans une telle cellule mémoire Mi. Lorsque la tension analogique d'entrée Vin est inférieure à la ième tension de référence Vi, la sortie du ième comparateur délivre une tension analogique de sortie Ci qui est quasiment nulle. Lorsque la tension analogique d'entrée Vin devient supérieure à Vi, la tension Ci croît rapidement, mais d'une manière non-instantanée, vers une tension non nulle proche de la tension d'alimentation du circuit. La tension Ci conserve cette valeur jusqu'à ce que la tension analogique d'entrée Vin redevienne inférieure à la tension de référence Vi. La tension analogique Ci décroît alors rapidement, mais d'une manière non-instantanée, vers une tension quasiment nulle. La tension Ci conserve cette valeur jusqu'à ce que la tension analogique d'entrée Vin redevienne supérieure à la tension de référence Vi. La tension Ci croît alors à nouveau rapidement, mais d'une manière non-instantanée, vers une tension non nulle proche de la tension d'alimentation du circuit, et conserve cette valeur tant que la tension analogique d'entrée Vin reste supérieure à la tension de référence Vi.

Dans ce cas de figure, la bascule D D0 ne détecte pas la fluctuation de la tension analogique de sortie Ci du comparateur. Son signal de sortie Q0 bascule vers le niveau haut lors du premier front montant du signal d'horloge Ck. Lors du second front montant du signal d'horloge Ck, la tension Ci présente une transition avant de reprendre une valeur non nulle. Néanmoins, le signal d'horloge Ck qui cadence les bascules mémoire D D0 et D1, ayant une fréquence deux fois plus faible que la fréquence d'échantillonnage, assure aux bascules mémoire une plus grande immunité aux phénomènes de métastabilité. Le signal de sortie Q0 de la bascule mémoire D0 reste donc au niveau haut. La bascule D D1, par contre, ne détecte pas le premier passage de la tension d'entrée analogique Vin au-dessus de la tension de référence Vi, mais la quasi-nullité de la tension Ci lors du premier front descendant du signal d'horloge Ck provoque le maintien du signal de sortie Q1 à l'état bas jusqu'au deuxième front descendant du signal d'horloge Ck, lors duquel la valeur non-nulle de la tension Ci provoque le basculement vers le niveau haut du signal de sortie Q1 de la bascule D D1. Lorsque le signal d'horloge Ck est à l'état bas, le signal de sortie Si du multiplexeur est le signal de sortie Q0 de la bascule D D0, et lorsque le signal d'horloge Ck est à l'état haut, le signal de sortie Si du multiplexeur est le signal de sortie Q1 de la bascule D D1. Le signal de sortie Si de la cellule mémoire Mi rend donc compte de la fluctuation de la tension analogique de sortie Ci du comparateur, et donc également de la fluctuation de la tension analogique d'entrée Vin.

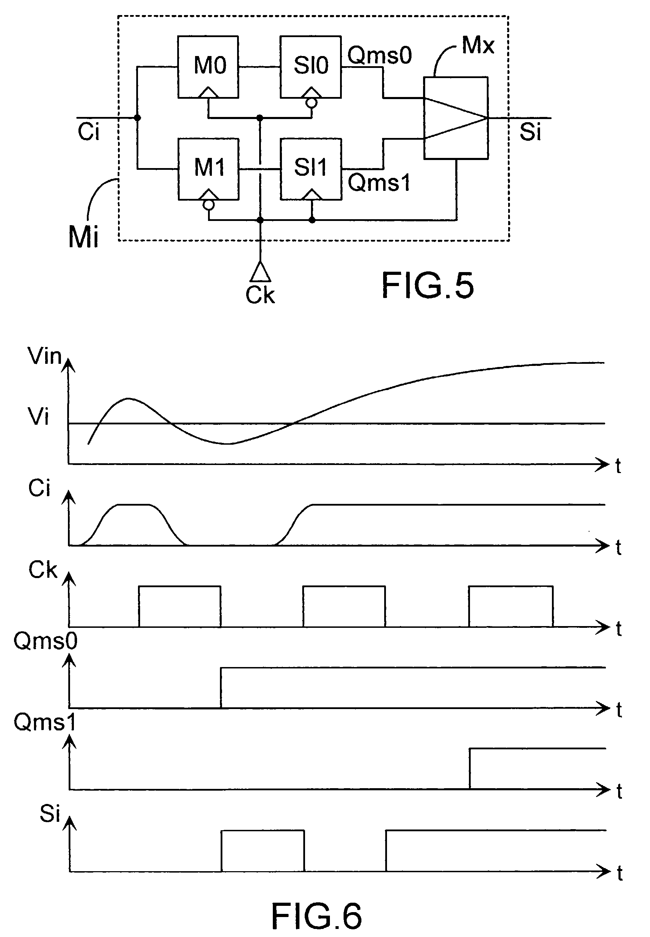

La figure 5 représente schématiquement l'une quelconque des 64 cellules mémoire que comporte l'étage de mémorisation 30 dans un convertisseur analogique/numérique parallèle conforme à un mode de réalisation avantageux de l'invention. Cette cellule mémoire Mi (pour i=0 à 63) comporte deux bascules de type Maître-Esclave, chacune composée de deux bascules D, M0, SI0 et M1, SI1, et un multiplexeur Mx. Chaque bascule D, M0, SI0, M1, SI1, est munie d'une entrée de données, d'une sortie de données et d'une entrée d'horloge. Le multiplexeur Mx est muni de deux entrées de données et d'une entrée de commande. Les entrées de données des deux bascules D M0 et M1, sont reliées l'une à l'autre et forment l'entrée de données de la cellule mémoire. La bascule D M0 reçoit sur son entrée d'horloge le signal d'horloge Ck, la bascule D SI0 reçoit sur son entrée d'horloge l'inverse dudit signal Ck et la sortie de données de la bascule D M0 est reliée à l'entrée de données de la bascule D SI0. La bascule D M1 reçoit sur son entrée d'horloge l'inverse du signal d'horloge Ck, la bascule D SI1 reçoit sur son entrée d'horloge ledit signal Ck et la sortie de données de la bascule D M1 est reliée à l'entrée de données de la bascule D SI1. Les sorties de données des deux bascules D SI0 et SI1 délivrent des signaux Qms0 et Qms1 et sont reliées aux entrées de données du multiplexeur Mx dont l'entrée de commande reçoit le signal d'horloge Ck et dont la sortie forme la sortie de la cellule mémoire Mi.

La figure 6 est un ensemble de chronogrammes illustrant l'évolution de signaux présents dans une telle cellule mémoire Mi. Les évolutions de la tension analogique d'entrée Vin, de la tension de sortie analogique Ci du comparateur, et du signal d'horloge Ck sont identiques à celles représentées sur la figure 4. Les signaux de sortie Qms0 et Qms1 des bascules D SI0 et SI1 évoluent donc comme les signaux de sortie Q0 et Q1 de la figure 4, avec un décalage dans le temps d'une demi-période du signal d'horloge Ck. Lorsque le signal d'horloge Ck est à l'état bas, le signal de sortie Si du multiplexeur est le signal de sortie Qms0 de la bascule D SI0, et lorsque le signal d'horloge Ck est à l'état haut, le signal de sortie Si du multiplexeur est le signal de sortie Qms1 de la bascule D SI1. Le signal de sortie Si de la cellule mémoire Mi rend donc compte de la fluctuation de la tension analogique de sortie Ci du comparateur, et donc également de la fluctuation de la tension analogique d'entrée Vin. Le signal d'horloge Ck qui cadence les bascules mémoire M0, SI0 et M1, SI1, a ainsi une fréquence deux fois plus faible que la fréquence d'échantillonnage.

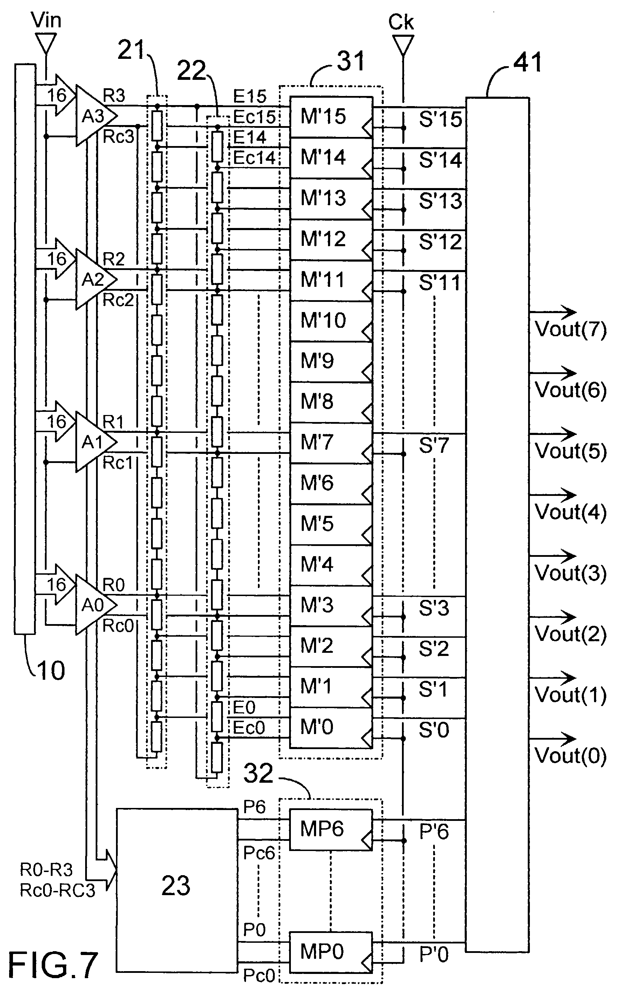

La figure 7 représente partiellement un convertisseur analogique/numérique utilisant les techniques de repliement et d'interpolation. Dans le cas décrit ici, ce convertisseur reçoit une tension d'entrée analogique Vin à convertir en un signal de sortie numérique codé sur 8 bits Vout(0...7). Ce convertisseur comprend :

.   une échelle de résistances 10, formée de 64 résistances placées en série entre une borne positive et une borne négative d'alimentation, respectivement Vtop et Vbot, résistances fournissant à leurs noeuds intermédiaires 64 tensions dites de référence, V0, V1,...V63, V0 étant égale à Vbot.

.   des étages de repliement A0, A1, A2, A3, composés chacun d'un jeu de comparateurs agencés de manière à engendrer un signal, respectivement R1, R2, R3, R4, dit de repliement, évoluant de manière quasi-sinusoïdale avec la tension analogique d'entrée, et un signal opposé à ce signal de repliement, respectivement Rc1, Rc2, Rc3, Rc4,

.   deux étages d'interpolation 21 et 22, le premier recevant les signaux de repliement R1, R2, R3, R4, le second recevant leurs opposés Rc1, Rc2, Rc3, Rc4, chaque étage d'interpolation 21, 22, étant composé de 16 éléments d'impédance, de préférence des résistances de même valeur, montés en pont diviseur de manière à ce que les signaux E0...E15, dits signaux d'échantillonnage, engendrés aux bornes des éléments du premier étage d'interpolation 21 représentent des divisions des signaux de repliement, les signaux Ec0...Ec15 engendrés par le deuxième étage d'interpolation 22 leur étant opposés,

.   un détecteur de cycle 23 recevant les signaux de repliement R1, R2, R3, R4 et leurs opposés Rc1, Rc2, Rc3, Rc4, et fournissant des signaux P0...P6 dits pointeurs de cycle et des signaux Pc0...Pc6 opposés à ceux-ci, permettant d'identifier celui des cycles des signaux d'échantillonnage E0...E15 qui est significatif de la valeur de la tension analogique d'entrée Vin,

.   un premier étage de mémorisation 31 composé d'éléments de mémorisation M'0...M'15, dits cellules mémoire, chaque cellule mémoire M'i (pour i=0 à 15) étant munie de deux entrées de données, d'une sortie et d'une entrée d'horloge et recevant sur ses entrées de données un signal d'échantillonnage Ei et son opposé Eci, toutes les cellules mémoire M'0...M'15 composant le premier étage de mémorisation 31 recevant sur leurs entrées d'horloge un même signal Ck dit signal d'horloge,

.   un deuxième étage de mémorisation 32 composé de cellules mémoire MP0...MP6, chaque cellule mémoire MPj (pour j=0 à 6) recevant sur ses entrées de données un signal pointeur de cycle Pj et son opposé Pcj, toutes les cellules mémoire MP0...MP6 composant le deuxième étage de mémorisation 32 recevant sur leurs entrées d'horloge le signal d'horloge Ck,

.   un encodeur binaire 41, lequel encodeur 41 reçoit en entrée les sorties des étages de mémorisation et fournit le signal de sortie numérique du convertisseur Vout(0...7).

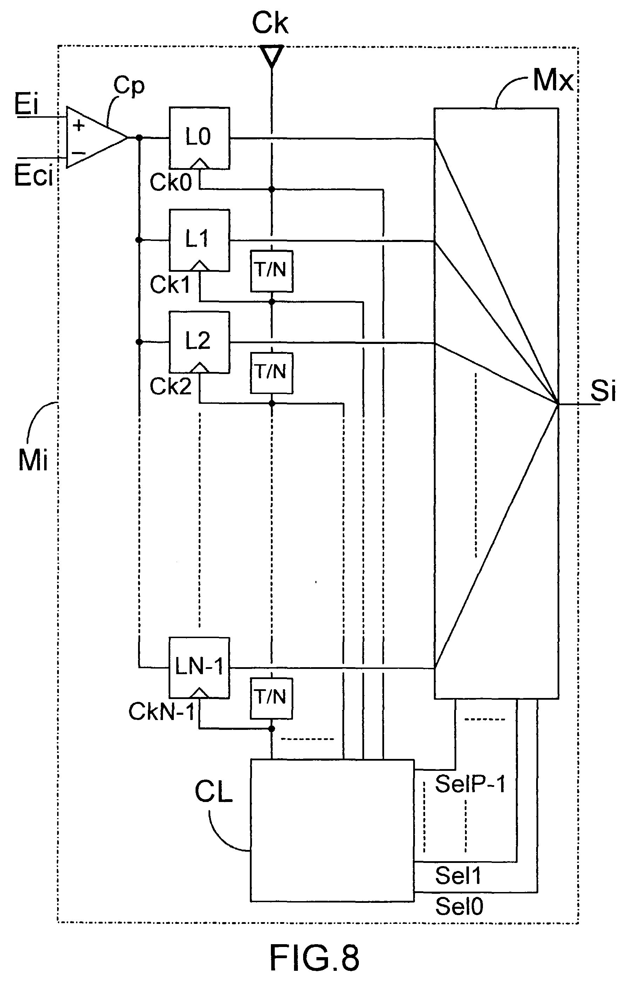

La figure 8 représente schématiquement l'une quelconque des seize cellules mémoire M'0...M'15 que comporte l'étage de mémorisation 31 dans un convertisseur analogique/numérique utilisant les techniques de repliement et d'interpolation conforme à l'invention. Les sept cellules mémoires MP0...MP6 qui composent le deuxième étage de mémorisation 32 ont également la même structure. Cette cellule mémoire M'i (pour i=0 à 15) comporte un comparateur Cp, N bascules dites bascules mémoire L0, L1,...LN-1, un multiplexeur Mx et un module logique CL dit module de commande. Chaque bascule mémoire L0, L1,...LN-1 est munie d'une entrée de données, d'une sortie de données et d'une entrée d'horloge. Le multiplexeur Mx est muni de N entrées de données, d'une sortie formant la sortie de cellule mémoire, et de P entrées de commande, N et P étant tels que $N=2^P$. Le module de commande CL est muni de N entrées et de P sorties. Les entrées du comparateur Cp sont reliées aux entrées de données de la cellule mémoire. Toutes les entrées de données des bascules mémoire L0, L1,...LN-1 sont reliées ensemble à la sortie du comparateur Cp. La jème bascule mémoire (pour j=0 à N-1) reçoit sur son entrée d'horloge le signal d'horloge retardé, par l'intermédiaire d'une cellule à retard, de j.T/N , où T est la période du signal d'horloge. Les sorties de données des M bascules mémoire L0, L1,...LN-1 sont reliées aux N entrées de données du multiplexeur Mx dont les P entrées de commande sont reliées aux P sorties du module de commande CL. Chacune des N entrées du module de commande CL est reliée à l'une des entrées d'horloge Ck0, Ck1,...CkN-1 des N bascules mémoire. Les P sorties Sel0, Sel1,...SelP-1 du module de commande CL sont telles que le multiplexeur Mx délivre sur sa sortie, pendant chaque (j+1)ème fraction de période de durée T/N, le signal de sortie de la jème bascule mémoire Lj.

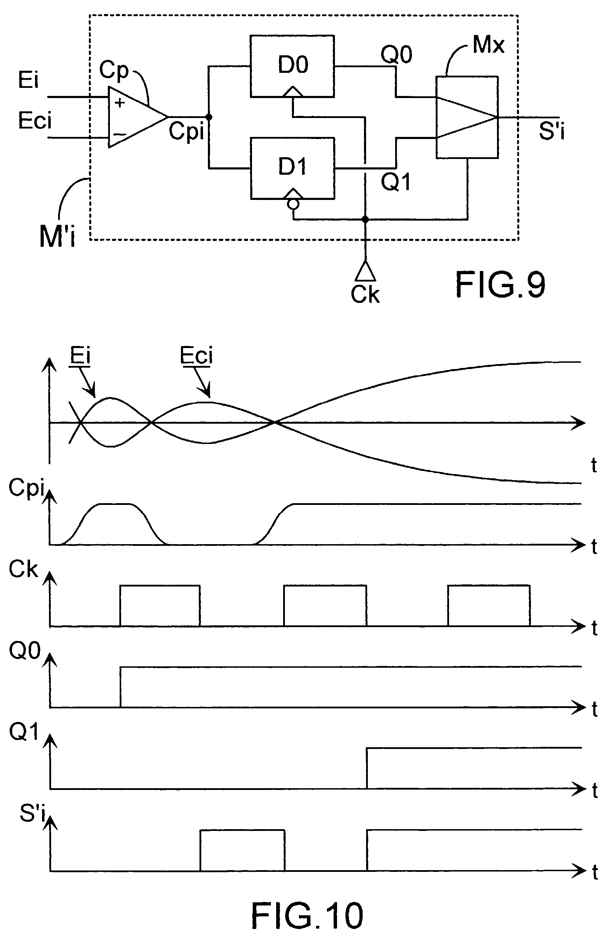

La figure 9 représente schématiquement l'une quelconque des seize cellules mémoire M'0...M'15 que comporte l'étage de mémorisation 31 dans un convertisseur analogique/numérique utilisant les techniques de repliement et d'interpolation conforme à un mode de réalisation particulier de l'invention. Les sept cellules mémoires MP0...MP6 qui composent le deuxième étage de mémorisation 32 ont également la même structure. Cette cellule mémoire M'i (pour i=0 à 15) comporte un comparateur Cp, deux bascules D, D0 et D1, dites bascules mémoire et un multiplexeur Mx. Chaque bascule mémoire D0, D1 est munie d'une entrée de données, d'une sortie de données et d'une entrée d'horloge. Le multiplexeur Mx est muni de deux entrées de données et d'une entrée de commande. Les entrées du comparateur Cp sont reliées aux entrées de données de la cellule mémoire. Les entrées de données des deux bascules mémoire D0 et D1 sont reliées ensemble à la sortie du comparateur. Une des bascules mémoire, D0, reçoit sur son entrée d'horloge le signal d'horloge Ck, l'autre, D1, reçoit sur son entrée d'horloge l'inverse dudit signal Ck. Les sorties de données des deux bascules mémoire D0 et D1 délivrent des signaux Q0 et Q1 et sont reliées aux entrées de données du multiplexeur Mx dont l'entrée de commande reçoit le signal d'horloge Ck et dont la sortie forme la sortie de la cellule mémoire M'i.

La figure 10 est un ensemble de chronogrammes illustrant l'évolution de signaux présents dans une telle cellule mémoire M'i. L'évolution des signaux d'échantillonnage Ei, Eci, qu'elle reçoit en entrée a été arbitrairement choisie de manière à assurer une certaine cohérence avec les cas de figure abordés plus haut, afin de faciliter la compréhension de l'invention. Lorsque le signal d'échantillonnage Ei a une valeur négative, la sortie Cpi du comparateur Cp délivre une tension analogique de sortie Cpi qui est quasiment nulle. Lorsque le signal d'échantillonnage Ei passe par zéro pour prendre une valeur positive, la tension Cpi croît rapidement, mais d'une manière non-instantanée, vers une tension non nulle proche de la tension d'alimentation du circuit. La tension Cpi conserve cette valeur jusqu'à ce que le signal d'échantillonnage Ei reprenne une valeur négative. La tension analogique Cpi décroît alors rapidement, mais d'une manière non-instantanée, vers une tension quasiment nulle. La tension Cpi conserve cette valeur jusqu'à ce que le signal d'échantillonnage Ei reprenne une valeur positive. La tension Cpi croît alors à nouveau rapidement, mais d'une manière non-instantanée, vers une tension non nulle proche de la tension d'alimentation du circuit, et conserve cette valeur tant que le signal d'échantillonnage Ei est positif. Dans ce cas de figure, l'évolution du signal Cpi est identique à celle du signal Ci de la figure 4. Les signaux Q0 et Q1 évoluent donc de même, et l'évolution du signal S'i est identique à celle du signal Si de la figure 4. Le signal de sortie S'i de la cellule mémoire M'i rend donc compte de la fluctuation de la tension analogique de sortie Cpi du comparateur, et donc également de la fluctuation du signal d'échantillonnage Ei. Le signal d'horloge Ck qui cadence les bascules mémoire D D0 et D1, a ainsi une fréquence deux fois plus faible que la fréquence d'échantillonnage.

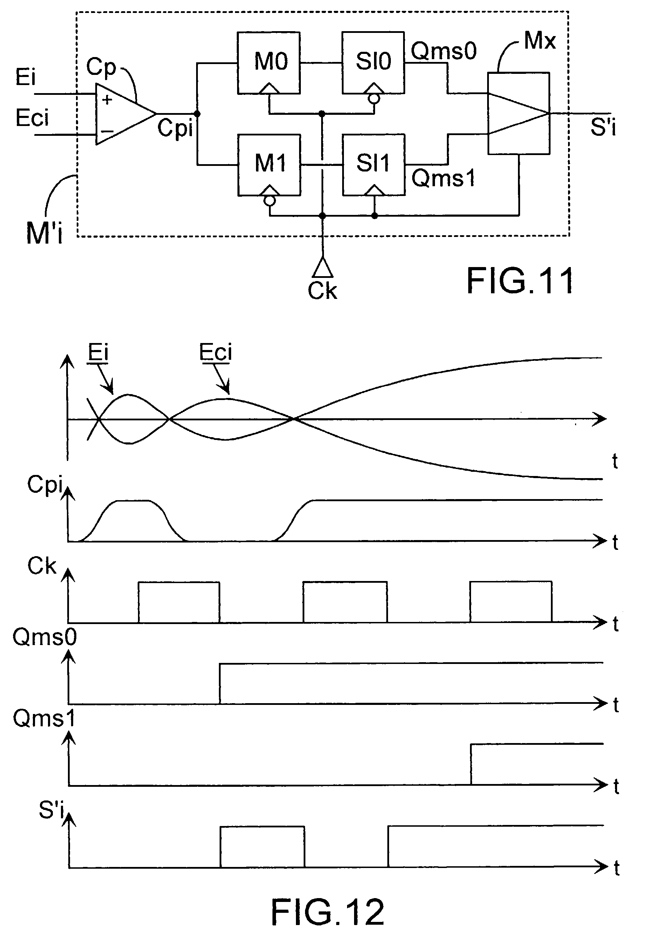

La figure 11 représente schématiquement l'une quelconque des seize cellules mémoire M'0...M'15 que comporte l'étage de mémorisation 31 dans un convertisseur analogique/numérique utilisant les techniques de repliement et d'interpolation conforme à un mode de réalisation avantageux de l'invention. Les sept cellules mémoires MP0...MP6 qui composent le deuxième étage de mémorisation 32 ont également la même structure. Cette cellule mémoire M'i (pour i=0 à 15) comporte un comparateur Cp, deux bascules de type Maître-Esclave, chacune composée de deux bascules D, M0, Sl0 et M1, Sl1, et un multiplexeur Mx. Chaque bascule D, M0, Sl0, M1, Sl1, est munie d'une entrée de données, d'une sortie de données et d'une entrée d'horloge. Le multiplexeur Mx est muni de deux entrées de données et d'une entrée de commande. Les entrées du comparateur sont reliées aux entrées de données de la cellule mémoire. Les entrées de données des deux bascules D M0 et M1, sont reliées ensemble à la sortie du comparateur Cp. La bascule D M0 reçoit sur son entrée d'horloge le signal d'horloge Ck, la bascule D Sl0 reçoit sur son entrée d'horloge l'inverse dudit signal Ck et la sortie de données de la bascule D M0 est reliée à l'entrée de données de la bascule D Sl0. La bascule D M1 reçoit sur son entrée d'horloge l'inverse du signal d'horloge Ck, la bascule D SI1 reçoit sur son entrée d'horloge ledit signal Ck et la sortie de données de la bascule D M1 est reliée à l'entrée de données de la bascule D SI1. Les sorties de données des deux bascules D SI0 et SI1 délivrent des signaux Qms0 et Qms1 et sont reliées aux entrées de données du multiplexeur Mx dont l'entrée de commande reçoit le signal d'horloge Ck et dont la sortie forme la sortie de la cellule mémoire M'i.

La figure 12 est un ensemble de chronogrammes illustrant l'évolution de signaux présents dans une telle cellule mémoire M'i. Les évolutions du signal d'échantillonnage Ei, de la tension de sortie analogique Cpi du comparateur, et du signal d'horloge Ck sont identiques à celles représentées sur la figure 10. Les signaux de sortie Qms0 et Qms1 des bascules D SI0 et SI1 évoluent donc comme les signaux de sortie Q0 et Q1 de la figure 10, avec un décalage dans le temps d'une demipériode du signal d'horloge Ck. Lorsque le signal d'horloge Ck est à l'état bas, le signal de sortie Si du multiplexeur est le signal de sortie Qms0 de la bascule D SI0, et lorsque le signal d'horloge Ck est à l'état haut, le signal de sortie Si du multiplexeur est le signal de sortie Qms1 de la bascule D SI1. Le signal de sortie Si de la cellule mémoire Mi rend donc compte de la fluctuation de la tension analogique de sortie Cpi du comparateur, et donc également de la fluctuation du signal d'échantillonnage Ei. Le signal d'horloge Ck qui cadence les bascules mémoire M0, SI0 et M1, SI1, a ainsi une fréquence deux fois plus faible que la fréquence d'échantillonnage.

**Revendications**

1. Convertisseur analogique/numérique, recevant une tension d'entrée analogique à convertir en un signal de sortie numérique, comprenant :

   . une échelle de résistances placées en série entre une borne positive et une borne négative d'alimentation, résistances fournissant à leurs noeuds intermédiaires une pluralité de tensions dites de référence,
   . un étage de comparateurs, chacun réalisant la comparaison de la tension d'entrée analogique avec l'une des tensions de référence,
   . un étage de mémorisation composé d'éléments de mémorisation dits cellules mémoire, chaque cellule mémoire étant munie d'une entrée de données, d'une sortie de données et d'une entrée d'horloge, et recevant sur son entrée de données le signal de sortie d'un comparateur, toutes les cellules mémoire composant l'étage de mémorisation recevant sur leurs entrées d'horloge un même signal dit signal d'horloge,
   . un encodeur binaire, lequel encodeur reçoit en entrée les sorties de l'étage de mémorisation et fournit le signal de sortie numérique du convertisseur,

   caractérisé en ce que chaque cellule mémoire de l'étage de mémorisation comporte N bascules dites bascules mémoire, un multiplexeur et un module logique dit module de commande, chaque bascule mémoire étant munie d'une entrée de données, d'une sortie de données et d'une entrée d'horloge, le multiplexeur étant muni de N entrées de données, d'une sortie formant la sortie de cellule mémoire, et de P entrées de commande, N et P étant tels que $N=2^P$, le module de commande étant muni de N entrées et de P sorties, les entrées de données des bascules mémoire étant toutes reliées ensemble à l'entrée de données de la cellule mémoire, la jème bascule mémoire (pour j=0 à N-1) recevant sur son entrée d'horloge le signal d'horloge retardé de $j.T/N$, où T est la période du signal d'horloge, les sorties de données des N bascules mémoire étant reliées aux N entrées de données du multiplexeur dont les P entrées de commande sont reliées aux P sorties du module de commande, module de commande dont chacune des N entrées est reliée à l'une des entrées d'horloge des N bascules, et dont les P sorties sont telles que le multiplexeur délivre sur sa sortie, pendant chaque (j+1)ème fraction de période de durée T/N, le signal de sortie de la jème bascule mémoire.

2. Convertisseur analogique/numérique selon la revendication 1, caractérisé en ce que les bascules mémoire contenues dans les cellules mémoire de l'étage de mémorisation sont des bascules D.

3. Convertisseur analogique/numérique selon la revendication 1, caractérisé en ce que les bascules mémoire contenues dans les cellules mémoire de l'étage de mémorisation sont des bascules de type Maître-Esclave.

4. Convertisseur analogique/numérique selon l'une quelconque des revendications 1 à 3, caractérisé en ce que chaque cellule mémoire de l'étage de mémorisation comporte deux bascules dites bascules mémoire et un multiplexeur, chaque bascule mémoire étant munie d'une entrée de données, d'une sortie de données et d'une entrée d'horloge, le multiplexeur étant muni de deux entrées de données et d'une entrée de commande, les entrées de données des deux bascules mémoire étant reliées l'une à l'autre et formant l'entrée de données de la cellule mémoire, une des bascules mémoire recevant sur son entrée d'horloge le signal d'horloge, l'autre recevant sur son entrée d'horloge l'inverse dudit signal, les sorties de données des deux bascules mémoire étant reliées aux entrées de données du multiplexeur dont l'entrée de commande reçoit le signal d'horloge et dont la sortie forme la sortie de la cellule mémoire.

5. Convertisseur analogique/numérique, recevant une tension d'entrée analogique à convertir en un signal de sortie numérique, comprenant :

. une échelle de résistances placées en série entre une borne positive et une borne négative d'alimentation, résistances fournissant à leurs noeuds intermédiaires une pluralité de tensions dites de référence,

. des étages dits de repliement, composés chacun d'un jeu de comparateurs agencés de manière à engendrer un signal, dit de repliement, évoluant de manière quasi-sinusoïdale avec la tension analogique d'entrée, et un signal opposé à ce signal de repliement,

. un premier et un deuxième étages d'interpolation, le premier recevant les signaux de repliement, le second recevant leurs opposés, chaque étage d'interpolation étant composé d'éléments d'impédance, de préférence des résistances de même valeur, montés en pont diviseur de manière à ce que les signaux, dits signaux d'échantillonnage, engendrés aux bornes des éléments du premier étage d'interpolation représentent des divisions des signaux de repliement, les signaux engendrés par le deuxième étage d'interpolation leur étant opposés,

. un détecteur de cycle recevant les signaux de repliement et leurs opposés et fournissant des signaux dits pointeurs de cycle et des signaux opposés à ceux-ci, permettant d'identifier celui des cycles des signaux d'échantillonnage qui est significatif de la valeur de la tension analogique d'entrée,

. un premier étage de mémorisation composé d'éléments de mémorisation, dits cellules mémoire, chaque cellule mémoire étant munie de deux entrées de données, d'une sortie de données et d'une entrée d'horloge et recevant sur ses entrées de données un signal d'échantillonnage et son opposé, chaque cellule mémoire comportant un comparateur d'entrée dont les entrées sont reliées aux entrées de données de la cellule mémoire, toutes les cellules mémoire composant le premier étage de mémorisation recevant sur leurs entrées d'horloge un même signal dit signal d'horloge,

. un deuxième étage de mémorisation composé de cellules mémoire, chacune recevant sur ses entrées de données un signal pointeur de cycle et son opposé, toutes les cellules mémoire composant le deuxième étage de mémorisation recevant sur leurs entrées d'horloge le signal d'horloge,

. un encodeur binaire, lequel encodeur reçoit en entrée les sorties des étages de mémorisation et fournit le signal de sortie numérique du convertisseur,

caractérisé en ce que les cellules mémoire des étages de mémorisation comportent chacune N bascules dites bascules mémoire, un multiplexeur et un module logique dit module de commande, chaque bascule mémoire étant munie d'une entrée de données, d'une sortie de données et d'une entrée d'horloge, le multiplexeur étant muni de N entrées de données et de P entrées de commande et d'une sortie formant la sortie de cellule mémoire, N et P étant tels que N=$2^P$, le module mémoire étant muni de N entrées et de P sorties, toutes les entrées de données des bascules mémoire étant reliées ensemble à la sortie du comparateur d'entrée de la cellule mémoire, la jème bascule mémoire (pour j=0 à N-1) recevant sur son entrée d'horloge le signal d'horloge retardé de j.T/N, où T est la période du signal d'horloge, les sorties de données des N bascules mémoire étant reliées aux N entrées de données du multiplexeur dont les P entrées de commande sont reliées aux P sorties du module de commande, module de commande dont chacune des N entrées est reliée à l'une des entrées d'horloge des N bascules, et dont les P sorties sont telles que le multiplexeur délivre sur sa sortie, pendant chaque (j+1)ème fraction de période de durée T/N, le signal de sortie de la jème bascule mémoire.

6. Convertisseur analogique/numérique selon la revendication 5, caractérisé en ce que les bascules mémoire contenues dans les cellules mémoire des étages de mémorisation sont des bascules D.

7. Convertisseur analogique/numérique selon la revendication 5, caractérisé en ce que les bascules mémoire contenues dans les cellules mémoire des étages de mémorisation sont des bascules de type Maître-Esclave.

8. Convertisseur analogique/numérique selon l'une quelconque des revendications 5 à 7, caractérisé en ce que chaque cellule mémoire de l'étage de mémorisation comporte deux bascules dites bascules mémoire et un multiplexeur, chaque bascule mémoire étant munie d'une entrée de données, d'une sortie de données et d'une entrée d'horloge, le multiplexeur étant muni de deux entrées de données et d'une entrée de commande, les entrées de données des deux bascules mémoire étant reliées ensemble à la sortie du comparateur d'entrée de la cellule mémoire, une des bascules mémoire recevant sur son entrée d'horloge le signal d'horloge, l'autre recevant sur son entrée d'horloge l'inverse dudit signal, les sorties de données des deux bascules mémoire étant reliées aux entrées de données du multiplexeur dont l'entrée de commande reçoit le signal d'horloge et dont la sortie forme la sortie de la cellule mémoire.

9. Cellule mémoire, munie d'une entrée de données, d'une sortie de données et d'une entrée d'horloge, laquelle reçoit un signal dit signal d'horloge, caractérisée en ce qu'elle comporte N bascules dites bascules mémoire, un multiplexeur et un module logique dit module de commande, chaque bascule mémoire étant munie d'une entrée de données, d'une sortie de données et d'une entrée d'horloge, le multiplexeur étant muni de N entrées de données, d'une sortie formant la sortie de cellule mémoire, et de P entrées de commande, N et P étant tels que $N=2^P$, le module de commande étant muni de N entrées et de P sorties, les entrées de données des bascules mémoire étant toutes reliées ensemble à l'entrée de la cellule mémoire, la jème bascule mémoire (pour j=0 à N-1) recevant sur son entrée d'horloge le signal d'horloge retardé de j.T/N, où T est la période du signal d'horloge, les sorties de données des N bascules mémoire étant reliées aux N entrées de données du multiplexeur dont les P entrées de commande sont reliées aux P sorties du module de commande, module de commande dont chacune des N entrées est reliée à l'une des entrées d'horloge des N bascules, et dont les P sorties sont telles que le multiplexeur délivre sur sa sortie, pendant chaque (j+1)ème fraction de période de durée T/N, le signal de sortie de la jème bascule mémoire.

10. Cellule mémoire selon la revendication 9, caractérisée en ce que les bascules mémoire qu'elle contient sont des bascules D.

11. Cellule mémoire selon la revendication 9, caractérisée en ce que les bascules mémoire qu'elle contient sont des bascules de type Maître-Esclave.

12. Cellule mémoire selon l'une quelconque des revendications 9 à 11, caractérisée en ce qu'elle comporte deux bascules dites bascules mémoire et un multiplexeur, chaque bascule mémoire étant munie d'une entrée de données, d'une sortie de données et d'une entrée d'horloge, le multiplexeur étant muni de deux entrées de données et d'une entrée de commande, les entrées de données des deux bascules mémoire étant reliées ensemble et formant l'entrée de la cellule mémoire, une des bascules mémoire recevant sur son entrée d'horloge le signal d'horloge reçu sur l'entrée d'horloge de la cellule mémoire, l'autre bascule mémoire recevant sur son entrée d'horloge l'inverse dudit signal, les sorties de données des deux bascules mémoire étant reliées aux entrées de données du multiplexeur dont l'entrée de commande reçoit le signal d'horloge et dont la sortie forme la sortie de la cellule mémoire.

FIG.1

FIG.2

FIG.3

FIG.4

FIG.5

FIG.6

FIG.7

FIG.8

FIG.9

FIG.10

FIG.11

FIG.12

Office européen
des brevets

**RAPPORT DE RECHERCHE EUROPEENNE**

Numero de la demande

EP 97 20 0843

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| D,Y | IEEE JOURNAL OF SOLID-STATE CIRCUITS, vol. 22, no. 6, 1 Décembre 1987, pages 944-953, XP000560513 GRITFT VAN DE R E J ET AL: "AN 8-BIT VIDEO ADC INCORPORATING FOLDING AND INTERPOLATION TECHNIQUES" * figures 2,5 * | 1-12 | H03M1/06 G06F5/06 //H03M1/36 |
| Y | IBM TECHNICAL DISCLOSURE BULLETIN, vol. 38, no. 7, 1 Juillet 1995, pages 87-89, XP000521616 "METASTABILITY REDUCTION IN HIGH-SPEED ANALOG-T-DIGITAL CONVERTERS BY ALTERNATING LATCHES" * page 87, ligne 1 - ligne 6; figure 1 * * page 88, ligne 3 - ligne 10 * | 1,2,4-6, 8-10,12 | |
| Y | SIEMENS COMPONENTS, vol. 20, no. 5, Octobre 1985, MUNCHEN DE, pages 210-211, XP002022473 "SDA 8010 - ultra-fast 8-bit A/D converter" * figure 1 * | 3,7,11 | |
| A | WO 95 10897 A (NOKIA TELECOMMUNICATIONS OY) 20 Avril 1995 * figure 2 * | 1,5,9 | **DOMAINES TECHNIQUES RECHERCHES (Int.Cl.6)** H03M G06F |
| A | NUCLEAR INSTRUMENTS AND METHODS, 15 AUG. 1972, NETHERLANDS, vol. 103, no. 1, ISSN 0029-554X, pages 157-165, XP002022474 PORGES K G ET AL: "Design of shift register delays for random asynchronous data input" * figure 7 * | 1,5,9 | |

Le présent rapport a été établi pour toutes les revendications

| Lieu de la recherche | Date d'achèvement de la recherche | Examinateur |
|---|---|---|
| LA HAYE | 22 Avril 1997 | Beindorff, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)